# EUROPEAN PATENT APPLICATION

(11) **EP 0 896 367 A2**
(43) Date of publication of application: **10.02.1999**
(21) Application number: 98112097.5
(22) Date of filing: 01.07.1998
(51) Int. Cl.: H01L 21/60, H01L 21/48, H01L 23/498

(54) **Packaging power semiconductors**

(30) Priority: 05.08.1997 US 906051
(71) Applicant: Pace, Benedict G., Ronkonkoma, NY 11779 (US)
(72) Inventor: Pace, Benedict G., Ronkonkoma, NY 11779 (US)
(74) Representative: Königseder-Egerer, Claudia D.

(57) **Abstract**

An electronic packaging module for bonding of power semiconductor devices is claimed. The semiconductor device (140) is mounted on a base (170) and enclosed by a frame (150) and a (110) lid. The lid is an insulating substrate having a conductive pattern with protuberances (131, 132) on the conductive pattern of the substrate. The protuberances are of a soft, ductile metal capable of being metallurgically bonded to the metallization pads of semiconductor devices. The metal protuberances are bonded to the semiconductor device joining it to the lid, and through the conductive pattern of the lid connecting the device to the input/output contacts (114, 115, 116) of the package.

## Description

This invention is in the fields of ceramic chip carriers, hybrid circuits and multichip modules for electronic interconnections.

In one proposed package for power semiconductor chips, the chip is bonded to a metallic base; also bonded to the base is a frame which surrounds the chip. An alumina ceramic lid, provided with holes containing copper balls for contact to the chip, is bonded to the frame over the chip. The copper balls are soldered to the gold bumps on the chip and make contact through the lid to copper foils bonded to the outer alumina surface. Since the metallic base is bonded to the bottom of the frame, and the alumina lid is bonded over the top of the frame there is a height tolerance problem, because the height of the frame must compensate for any variation in thickness of the internal components of the package. To overcome this problem it has been proposed to make the alumina lid somewhat smaller than the frame and a ring of free standing copper foil between the frame and the lid would form a somewhat flexible medium to take up variations in the height of the package.

In other proposed packages, a copper foil is bonded to the wire bond gold bumps on the chip and part of the foil is formed into tabs which in one variation are insulated on one side with polyimide and then folded over to make contact with copper balls in the lid. In another variation foil tabs are bought out through the lid of the package, and the package hermetically sealed by soldering the foil tabs to copper foil lands bonded to the lid.

The mismatch of the thermal expansion coefficients of alumina and the copper foil leads to failure mechanisms that affect the adhesion of copper foil to the substrate and the hermetic seal of the package. When the copper foil is joined to the copper balls, the copper foil is deformed, stressed and thinned; it is subject to the further stress of thermal mismatch leading to breaks and stress corrosion.

In the packages for logic semiconductors, the flip chip or C4 (Controlled Collapse Chip Connection) has achieved the lowest impedance by eliminating wire bonds, and the highest packaging efficiency, up to 90% for a 10 mm x 10 mm die. Miniature flexible circuits have been designed to provide packaging efficiencies similar to the C4 process. The flexible circuits can be used with conventional integrated circuits having perimeter contacts. Gold conductors of the flexible circuit are thermosonically bonded the integrated circuits contacts. The conductors of the flexible circuit do not fan out from the integrated circuit contacts into the area around the chip, instead the conductors fan in underneath the chip terminating in a grid array of metal bumps underneath the chip for interconnection to second level packaging. The flexible circuit is bonded to the chip with an elastomeric adhesive 0.15 mm (6 mil) thick. The organic elastomeric adhesive and flexible circuit materials limit the temperature range in manufacture and use, do not permit good thermal transfer, make the package sensitive to moisture, and prevent use as hermetically sealed packages.

In one embodiment the present invention is an improved method of packaging a power semiconductor chip wherein a first surface of the chip is bonded to a base and a frame is attached to a lid and the base to enclose the chip. The chip has at least one power contact pad on its second surface which is attached to the lid. The improvement in the packaging method comprises: providing as the lid, a planar, insulating substrate, which has at least one conductive pattern layer on a first surface facing the chip; forming at least one soft, ductile, metal protuberance on at least one conductor of the conductive pattern layer on the first surface the lid, and connecting the conductive pattern of the lid to the chip by metallurgically bonding the protuberances to contact pads of the chip, the number of protuberances bonded to a power contact pad being sufficient to minimize the contact resistance and the power lost as heat (I²R) between the chip and the lid.

In another embodiment the invention is a package for a semiconductor chip having at least one power semiconductor. A first surface of the chip is bonded to a base; a frame attached to a lid, and the base is attached to the frame to enclose the chip. The chip has at least one power contact pad on its second surface. This embodiment is characterized in that the lid comprises an insulating substrate having a conductive pattern at least on a first surface facing the chip, the conductive pattern of the lid being connected to the chip through of soft, ductile, metal protuberances protruding from the conductive pattern layer on the surface the lid facing the chip. power semiconductor thereon. A first surface of each chip is bonded to a base, and a second surface of each chip has at least one power contact pad. Each chip is surrounded by a frame. All the frames that surround each chip are bonded to a common lid, and the base supporting each chip is bonded to a frame. The common lid is a rigid, planar, insulating substrate, and the area of the lid is large enough to accommodate all the chips. There is a conductive pattern on the insulating substrate of the lid. At least one conductive pattern layer on a first surface of the lid has a plurality of soft, ductile metal protuberances and the conductive pattern of the lid is metallurgically bonded by the protuberances to each of the contact pads on second surfaces of the chips.

In yet another embodiment, the invention is a compact, light weight package for power semiconductor devices with a built-in thermally conductive interface and high packaging efficiency.

In another embodiment, the invention is a compact, light weight package for an array of power semiconductor devices. The array of power semiconductor devices can be electrically interconnected or independent.

This invention relates to first level electronic packaging for power semiconductors, including power diodes, power field effect transistors (FETs) and power metal oxide field effect transistors (MOSFETs), bipolar power transistors and integral gate bipolar transistors (IGBTs), silicon controlled rectifiers (SCRs).

According to this invention a power semiconductor can be packaged with the back side of the power die brazed to a metal base or metal tab, and the other side of the die joined by a plurality of metal protuberances to a metallic conductive pattern. The metal base on one side and the sea of bumps on the other permit heat to be withdrawn from the power die from both sides of the package.

Packages for power semiconductor chips described herein have three parts: the chip bonded to a base, an insulating substrate as a lid, and a frame bonded to the base and lid and surrounding the chip. Preferably, the base is a material capable of conducting heat away from the chip such as a metal or a heat conducting ceramic beryllia or alumina or a heat conducting glass ceramic. Preferably the thermal coefficient of expansion of the base will be close to that of the chip.

Suitable substrates for the lid are planar insulating materials. Preferred materials are ceramic substrates comprising aluminum oxide, aluminum nitride, beryllium oxide, boron nitride, cordierite, mullite, silicon carbide and silicon nitride are suitable. Especially suitable are substrates whose thermal expansion characteristics are closely matched to that of the semiconductor devices such as silicon, sapphire and glass/ceramics comprising aluminum oxide, aluminum nitride, beryllium oxide, boron nitride, cordierite, mullite, silicon carbide and silicon nitride.

The lid will comprise a conductive pattern including the metal protuberances which are metallurgically bonded to the contact pads of the chip. Often the lid will have a plurality of protuberances contacting each of the large contact pads on the chip.

The conductive patterns of the lid may be prepared using the sputtered metal and high polymer dielectrics characteristic of the MCM-D (Multichip Module-Deposited) technique, but thick or thin film metallization, and fired, inorganic dielectrics are preferred.

The conductive pattern of the lid may be conveniently produced by thick film techniques. A thick film conductive pattern may be applied, or a non-patterned layer of thick film metallic paste applied over the surface of a ceramic substrate. The paste layer may cover the complete planar surface, or only a portion of the surface where metal conductors are required. The metallic paste may be selected from thick film conductor pastes containing copper, gold, platinum, palladium, silver or mixtures and alloys thereof. Copper and gold conductor pastes are preferred. One suitable gold paste contains 88% gold, 3-4% glass with 8-9% organic binder of ethyl cellulose and terpineol. A suitable copper paste is C7230^{tm} Copper Conductor Paste commercially available from Heraeus Inc., Cermalloy Div., West Conshohocken, PA 19428.

The paste on the substrate is dried and fired to convert it to a metallic layer. A gold paste is fired in air and a copper paste is fired in a nitrogen atmosphere, both at 850°c. The metal layer is preferably 8-12 µm thick after firing.

Alternatively, the metal layer may be deposited by a thin film technique. A suitable thin film metallization has a bonding layer of titanium/tungsten or chromium and 1-5 µm (40-200 microinches) of copper or gold.

For most power semiconductor packages, no fine line conductors are required. If the package includes a function that requires fine line conductors, a thick film or thin film metallization layer can be imaged with a photoresist and etched. A suitable etchant must remove all traces of the metal between the conductors without serious undercut the conductor edges. A suitable etchant for a gold layer is iodine in an aqueous solution of potassium iodide such as CGE-100^{tm} from Micro Pac Co., Garland, TX. Suitable copper etchants include sodium or ammonium peroxydisulfate solutions at 120-250 g/l, copper (II) chloride at 75-200 g/l, hydrogen peroxide 1-1.5 m/l in 1.5-3 molar sulfuric acid, 0.5-1.5 copper ammonium chloride at a pH of 8-9, and 30-48°Bé ferric chloride with 0.1 to 1.2 m/l hydrochloric acid. Copper etchants are used at temperatures between 15-50°C depending on the copper paste and etching solution used.

The conductive pattern layer on the surface of the lid facing the semiconductor die is preferably covered by an inorganic dielectric layer. The dielectric layer has openings to the conductive pattern to permit formation of soft, ductile metal protuberances which will bond to the die. The openings have a diameter at least 10 µm (0.4 mils) and less than the diameter of the contact pad of the chip, preferably at least 25 µm (1 mil) and preferably less than 250 µm (10 mils). A ceramic dielectric layer may be formed from a "green" ceramic with suitable openings, from a photoimageable ceramic layer or from a screen printed thick film dielectric.

In one process a thick film dielectric paste is screen printed over the metal conductive pattern. The dielectric paste is printed and fired to give a dielectric layer approximately 8-12 µm thick.

Openings in the dielectric may be formed photoimaging, screen printing or by laser ablation through the dielectric layer. When laser ablation is used the laser energy is controlled to prevent damage or destruction of the underlying conductors. The quantity of laser energy required, which varies with the composition and thickness of the dielectric layer, can be determined empirically. No via artmaster is required. The X-Y coordinates of the vias are fed to the laser controller.

Many commercially available thick film pastes are suitable for forming the dielectric layer. One suitable screen printable dielectric composition is CERMALLOY IP-9117^{tm} from Heraeus Inc., West Conshohocken, PA 19428. When laser ablation is used to form openings in the dielectric layer, the fired dielectric layer must be capable of maintaining its shape without reflow after laser ablation or after firing of subsequent layers. The dielectric layer must absorb the laser energy and form clean vias through the layer with minimum damage or penetration of the underlying conductor. Dielectric compositions which do not efficiently absorb the laser beam require high laser energy that either penetrates through the underlying conductor layer, cracks, burns or blisters the dielectric layer around the via, or forms an elevated ridge around the via.

In one alternative procedure, the conductive pattern layer is coated with a polymer such as polyimide or polybenzocyclobutane forming the dielectric layer and the openings are laser ablated, or photoimaged in the polymer before crosslinking the polymer. In another alternative procedure the conductive pattern layer is coated with a silica as the dielectric layer. The openings are laser ablated, or the silica dielectric is covered with a mask, and the openings are formed by chemical or plasma etching.

An important feature of the invention is the formation of metal protuberances on the package joined to the conductive pattern and capable of being metallurgically bonded to the contact pads of a power semiconductor. The metal protuberances may be simultaneously bonded to the pads of a semiconductor device, which is a simpler and faster process than the conventional, sequential wire bonding process. The substrates, "bumped" with metal protuberances in a simple process, are more economical, easier to prepare, and to use than the bumped chips common in "flip chip" technology.

The metal protuberances should be high enough above the surface of the electronic package to form a reliable metallurgical bond with the contact pads of the semiconductor device.

The protuberances should be greater than 5 µm high, preferably greater than 10 µm and more preferably greater than 50 µm high. The protuberances must be high enough to compensate for the variations due to the camber, planarity and overall size of the both the electronic package and the device, and not so high that they collapse and short circuit in the bonding process. On 96% alumina substrates, protuberances as low as 25 µm are effective in bonding semiconductor devices with length and breadth up to 5 mm, and protuberances up to 150 µm are also effective. Smaller protuberances are effective on smoother substrates such as polished 99% alumina ceramics. Still smaller protuberances are effective for still smoother surfaces such as silicon wafers.

The contact pads of such semiconductor devices are commonly metallized with aluminum or gold. The metal protuberances are capable of metallurgically bonding to the pads by thermocompression, thermosonic or ultrasonic means, or by soldering.

The metal of the metal protuberances is selected from the group comprising aluminum, copper, gold, indium, lead, silver, tin combinations and alloys of these metals.

Aluminum or gold protuberances are preferred when the metallization of the input/output pads of the semiconductor device is aluminum. Aluminum protuberances are formed by vacuum deposition of aluminum through a shadow mask. Gold protuberances are preferably formed by electrodeposition or electroless deposition. The protuberances can be formed by deposition of metal onto the conductive pattern through openings in a temporary and/or permanent mask which is over the pattern. The metallurgical bonds between the gold protuberances and the pads can be formed by thermocompression, thermosonic or ultrasonic bonding. Gold protuberances are also suitable for when the metallization of the semiconductor contact pad is gold. For thermocompression, thermosonic or ultrasonic bonding the metal protuberances should be soft, and ductile.

Indium metal protuberances are suitable for forming metallurgical bonds to gold metallization on the contact pads. The metal protuberances also may be lead/ indium or tin/indium alloys. The alloy metal protuberances are preferably overplated with a layer of pure indium. Indium and indium coated protuberances may be metallurgically bonded to the input/output pads of the semiconductor devices by an indium fusing or soldering process.

Before joining the chip to the lid the protuberances may vary in height. In addition there may be variations in the planarity and camber of the base, chip and lid. In the process of metallurgically bonding the chip to the protuberances of the lid, the soft, ductile metal of the protuberances flows slightly compensating for these variations and producing uniform bonding to the chip. During the process of metallurgically bonding the protuberances to the chip, it is important the chip be free to move toward the lid to take up the variations.

The frame of the package may have a minimum wall thickness of 25 µm (5 mils). The frame fits closely around the circuit dice so that the overall packaging efficiency is high. For hermetically sealed modules, the frame is made of ceramic or metal. A ceramic frame will preferably be metallized on its upper surface for soldering to a metal base. When hermetic sealing is not required the package may be sealed by a plastic frame or enclosure adhesively bonded to the base, e.g., with an epoxy adhesive.

Assembly of the package is easy when the frame encloses the chip during the process of bonding the protuberances to the chip. The chip is bonded to the base before assembling the package. In one embodiment of the assembly process, the frame is bonded to the lid and the base is slightly smaller than the frame, the base with the chip attached freely adjusts against the protuberances of the lid during bonding, e.g. thermocompression bonding.

Preferably the outside dimensions of the base would be about 2 mm (50 mils) smaller than the inside dimensions of the frame. In a second embodiment the frame is bonded to the base, and the lid is slightly smaller than the frame permitting adjustment during bonding of the protuberances to the chip. Preferably the outside dimensions of the lid would be about 2 mm (50 mils) smaller than the inside dimensions of the frame. In a third embodiment the frame is slightly larger than both the lid and the base, so the base and lid can freely move inside the frame.

After the protuberances are bonded to the chip, compressing force is maintained while the base, lid and frame are metallurgically or adhesively joined together. Thus the package is sealed in compression, which reinforces the bond between the lid and the chip. This provides a long lived package having greatly enhanced reliability without the need for the organic "underfill" adhesive that is frequently used in flip chip and C4 packages to reinforce the metallurgical bonds to the contacts.

In one embodiment the invention is a compact, ceramic, chip carrier or SCM, single chip module, with high packaging efficiency. The SCM has a conductive pattern on a ceramic substrate as a lid. The lid has contacts for interconnection to second level packaging and a metal or ceramic frame around the power semiconductor device or chip.

Where the service conditions for the package permit, a plastic frame or enclosure may be used. The base and the lid are then adhesively bonded to the frame, e.g. with an epoxy adhesive.

In an alternative approach, the frame is formed by molding plastic around the chip, sealing the chip between the lid and the base. Organic "underfill" adhesives may be used.

SCMs (Single Chip Modules) provide a rugged package for full functional testing and/or burn-in of semiconductors. After the testing and/or burn-in that provides known good die (KGD), the SCM can be mounted in a multichip package with packaging efficiency approaching or exceeding that of a wire-bonded chip. The length and breadth of the lid of an SCM package may be as small as 1.6 mm (40 mils) greater than the length and breadth of the die. Preferably the lid is smaller than 6 mm (150 mils) greater than the length and breadth of the die, and more preferably as small as 2.75 mm (70 mils) greater than the length and breadth of the die.

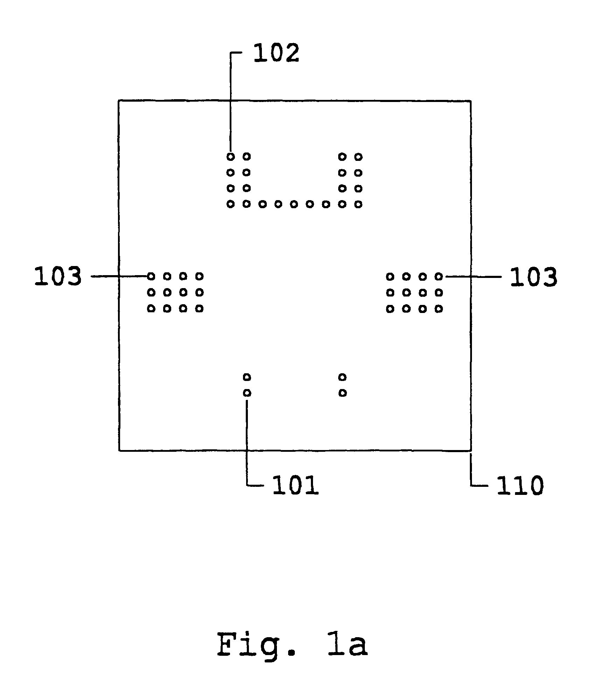

The preparation of a package for a power semiconductor device is illustrated in FIGs. **1a-1h.** The package was prepared for an IRFC-150^{tm}, a power field effect transistor (FET), available from the International Rectifier Corp. The IRFC-150 semiconductor die was a square piece of silicon 6.55 mm (258 mils) on a side and 3.8 mm (15 mils) thick. The drain is the back of the die and the source and gate are on the top surface.

FIG. **1a** shows a ceramic substrate **110** which was used as the lid in the package for a single IRFC-150 semiconductor die. The ceramic substrate was a square, each side 8.4 mm (330 mils) long. Groups of via holes **101, 102** and **103**, were drilled through the ceramic substrate in order to provide through-connections from the die side of the lid to the outside of the package. Via holes **101** were for the gate connections and via holes **102** and **103** were for the source and drain connections respectively. Each via hole was 0.15 mm (6 mils) in diameter.

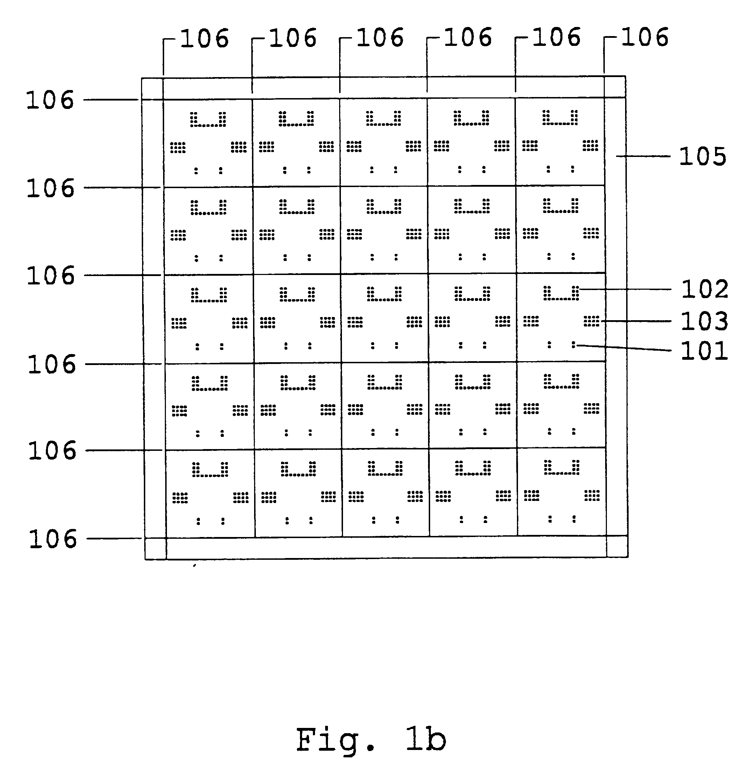

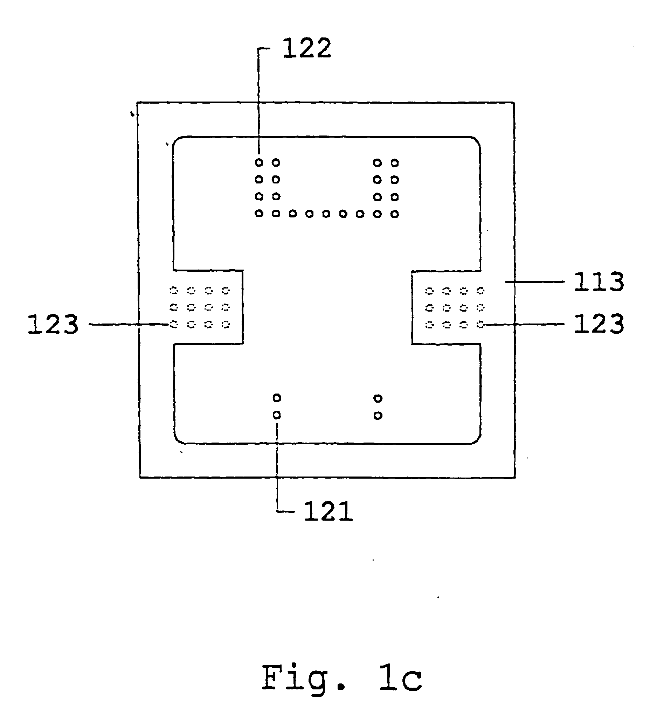

FIG **1b** shows a group of 25 ceramic substrates on a ceramic sheet **105** which was 50 mm x 50 mm (2 in. x 2 in.) square. The 25 ceramic substrates were processed as a unit. The ceramic sheet was scored along the lines **106** to permit individual substrates to be broken apart after processing.

The vias **101**, **102** and **103** of all 25 substrates in the ceramic sheet **105** were plugged with a silver/palladium thick film paste (DuPont No. 7988^{tm}) and then fired to form through-connections in the substrates. The paste has low shrinkage upon firing and forms highly conductive feed-through connections. Any thick film paste that exhibits low shrinkage and high conductivity could be used.

The through-connections **121** and **122** are shown in FIG. **1c**. A first, thick film, conductor pattern **113** was printed and fired on one side of the ceramic substrate **110** using a platinum/silver paste. The conductor **113** covered, and was connected to, the drain through-conductors **123**. Conductor **113** provided a metal layer for subsequent brazing of a frame to the ceramic substrate **110**. The conductors **113** on all 25 substrates in the ceramic sheet **105** were printed simultaneously.

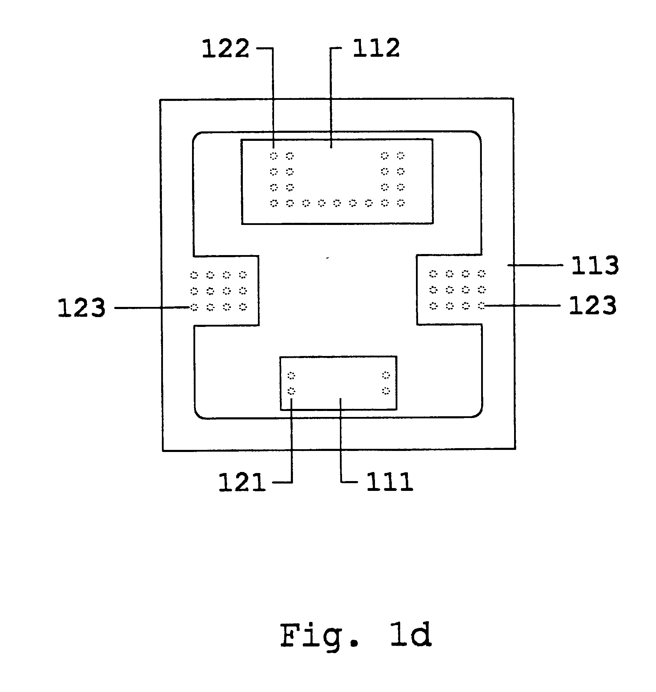

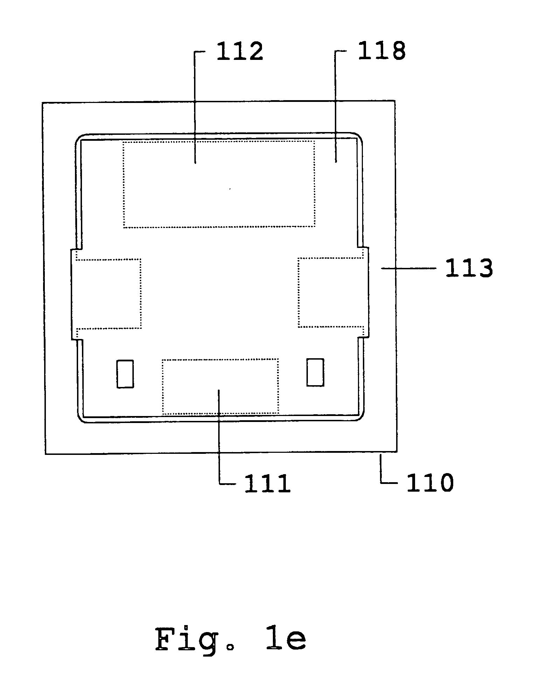

A second, thick film, conductive pattern, which is shown in FIG. **1d**, was printed and fired on the same side using a gold paste. The conductor **111** was connected to the gate through-conductors **121**, and the conductor **112** was joined to the source through-conductors **122**. All 25 substrates in the ceramic sheet **105** were printed simultaneously. A thick film dielectric **118**, shown in FIG. **1e**, was applied over the gate and source conductors **111** and **112**. The dielectric layer was 10-12 µm (0.4-0.5 mils) thick. Again, all 25 substrates in the ceramic sheet **105** (FIG. **1b**) were printed simultaneously.

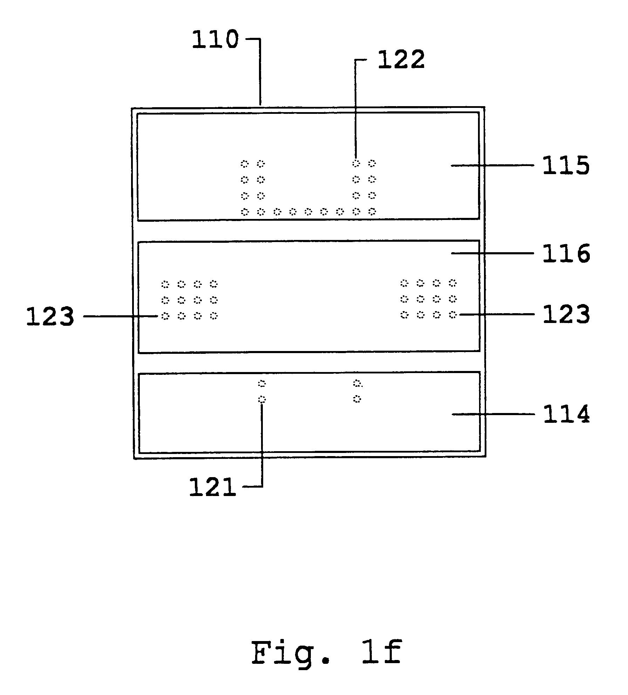

A third, thick film, conductive pattern, shown in FIG. **1f**, was printed with a platinum/silver paste on the opposite side of the ceramic substrate. Again, all 25 substrates in the ceramic sheet **105** (FIG. **1b**) were printed simultaneously. Conductor **114** was joined to the gate through-conductors, and conductors **115** and **116** were connected respectively to the source **122** and drain **123** through-conductors.

The conductors **114**, **115**, **116** and conductor **113** around the edge of the ceramic substrate **105** on the opposite side of the lid were masked with a temporary photoresist before gold plating. All 25 substrates in the ceramic sheet **105** were masked simultaneously.

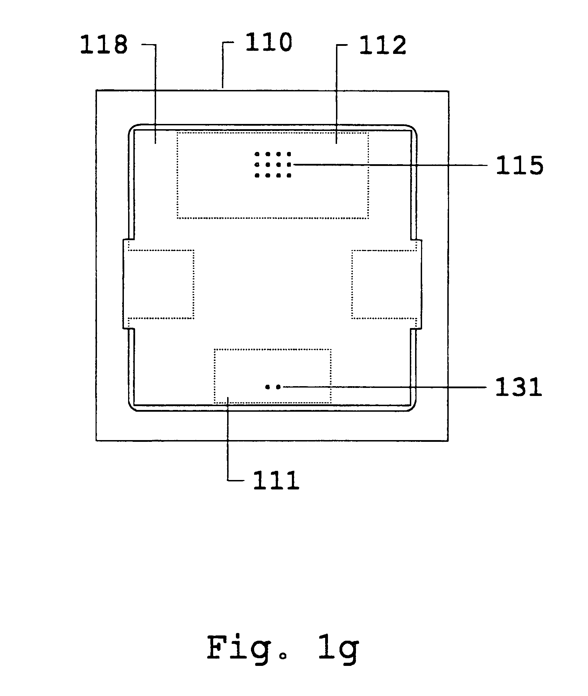

After masking the conductors, fifteen openings through the dielectric layer **118** to the source conductor **112** and two openings to the gate conductor **111** were made by laser ablation. A soft, ductile gold was electroplated into the openings. The gold electroplate grew from the conductors **111** and **112** through the openings and formed protuberances **131** and **132** shown in FIG. **1g**. The protuberances were 45-60 µm high and protruded 37-48 µm above the dielectric layer **118**. All 25 substrates in the ceramic sheet **105** were gold plated simultaneously.

The gold plating solution was the Aurall^{tm} 292 Gold Process, available from LeaRonal Inc., Freeport, NY 11520, USA. The Aurall 292 Gold Process uses a electroplating solution containing 8-16 g/l gold at a pH between 6 and 8, and is believed to contain a phosphonate chelating agent.

In order to prevent lateral growth of gold deposits, the plating conditions were tightly controlled to obtain uniform gold protuberances. The pH was maintained at 6.8-7.2, the current density was 0.72 amps/dm², the solution temperature was 26-40°C (preferably 29-31°C), and the solution was stirred strongly. In this plating solution, if the temperature is too high, there is excessive lateral growth; if the temperature is too low, the gold deposit becomes nodular.

After stripping the mask from the conductors **113, 114**, **115** and **116** the ceramic sheet **105** was severed along the scribed lines **106** (shown in FIG. **1b**) to separate it into 25 ceramic substrates **110**. Each substrate was a square having sides 8.4 mm (330 mils) long. Square frames of an iron-nickel-cobalt alloy (Kovar^{tm}) were provided which had sides 8.26 mm (325 mils) long and 6.3 mm (25 mils) high, and a wall thickness 0.7 mm (27.5 mils). The Kovar frame was brazed to the conductor **113**. The frame together with the ceramic substrate to which it was attached formed a square cavity with sides 6.86 mm (270 mils) long, which was 305 µm (12 mils) larger than the IRFC-150 die.

An IRFC-150 die, with the back (i.e. the drain) down, was put on a square, gold plated molybdenum base or tab; and the die was brazed to the molybdenum in a hydrogen furnace. The molybdenum was 0.8 mm (20 mils) thick and the sides were 6.65 mm (262 mils), which was 100 µm (4 mils) longer than the die.

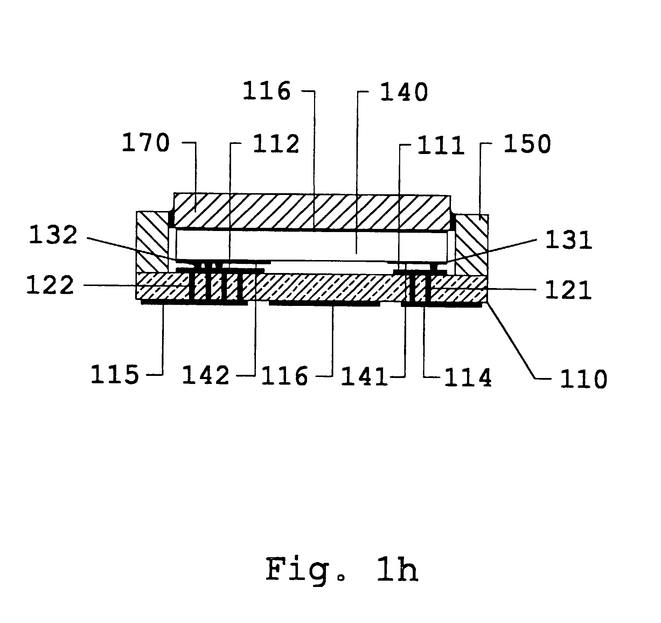

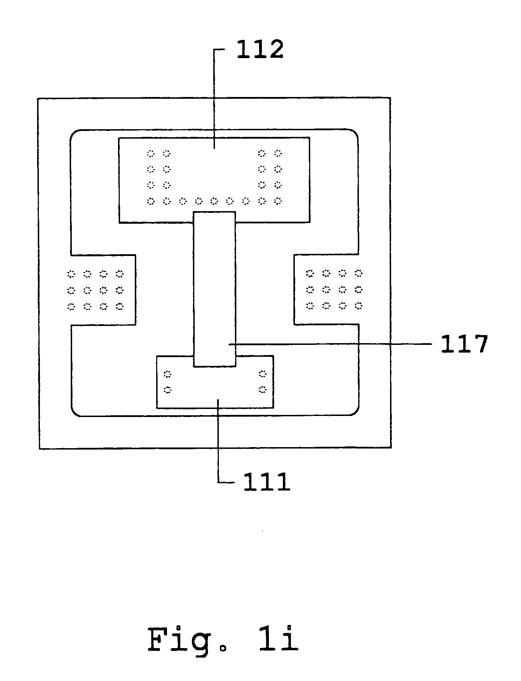

Referring to FIG. **1h**, the die **140** on the molybdenum base **170** was placed into the cavity formed by the frame **150** and the ceramic substrate **110**. Heat and pressure were applied. The gold protuberances were soft and ductile enough to adjust themselves for height differences from one to another; and a thermocompression bond was formed between the source pad **142** and gate pad **141** of the IRFC-150 die and the gold protuberances **132** and **131**. In this method of manufacturing the package there is no height problem because the molybdenum tab is inside the wall of the frame and is self adjusting for height. While maintaining heat and pressure, the molybdenum tab was soldered to the Kovar frame. The package was then cooled while continuing to maintain the compression pressure.

FIG. **1h** is a view of the assembled package in cross section. The gate **141** of the die has been thermocompression bonded to the gold protuberances **131**, and connected through the protuberances to the conductor **111,** and by the through-connections **121** to the gate pad of the package **114** . The source contact of the die **142** is similarly connected through protuberances **132**, conductor **112**, and through-connections **122** to the source pad of the package **115**. The drain of the die is connected to the molybdenum base **170**, through the molybdenum to the Kovar frame **150**, through the Kovar frame to the conductor **113**, and by the through-connections **123** (FIG. **1c**) to the drain pad of the package **116**. In addition to serving as the drain connection to the die, the molybdenum base is a thermal path for removing heat from the package.

The finished power package was tested and found to be fully functional. The package was very compact. The overall size of the package was only 8.4 mm (330 mils) in length and breadth and 1.1 mm high. Including the molybdenum base, it weighed 0.45 g. For comparison the conventional package, IRFP150^{tm}, (including its heat tab) is 21 mm (825 mils) long, 14 mm (550 mils) wide and 5 mm (20 mils) high; and it weighs 5.15 g.

In addition to the procedure described above, the ceramic package could be produced by alternative procedures such as co-fired ceramic techniques. The feed-through connections may be prepared by making through-holes **101, 102** and **103** (FIG. **1a**) in a green ceramic and plugging the holes with a refractory metal paste before firing. Likewise the drain **116**, source **115** and gate **114** contacts of the package shown in FIG. **1d**, and the conductive pattern of FIG. **1f** may be printed with refractory pastes on the green ceramic before firing. Even the dielectric layer **118** (FIG. **1e**) could be applied to the green ceramic before firing, or the dielectric layer **118** with the openings to the gate and source conductors **114** and **115** could be made with a photoprintable ceramic dielectric. Also the ceramic base could be prepared by thin film techniques. The ceramic base with source and gate contacts may also be prepared by a mixture of co-fired and thick film or thin film techniques.

In those power semiconductors that operate at very high voltage, there is a possibility for a short circuit between the power contact pad of the chip and the metal frame connected through the base to the back of the chip. A ceramic frame instead of the metal frame increases the insulation between the positive and negative contacts of the chip. It is especially advantageous to use green ceramics to form both the cofired lid and the frame as one unit to obtain the maximum insulation in the smallest volume. When a insulating frame is used or incorporated in the lid as in some cofired ceramics, one electrical connection will be made on one side of the package, and the other connections on the opposite side of the package.

To prevent electrostatic discharge (ESD) damage to power FETs, when power semiconductors packages are mounted on a higher level package an external high value resistor is connected across the source and gate contacts of the package. In another embodiment of the present invention ESD protection is easily incorporated in the power FET chip carrier package. This may be illustrated by referring to FIG. **1i** where a high value thick film resistor **117** is shown as printed between the gate conductor **111** and source conductor **112** to provide ESD protection.

Power module packages containing a plurality of power semiconductor devices are easily manufactured by the procedures described above. The power module package can be an array of independent power semiconductor devices, an array of interconnected devices, or a mixture of independent and interconnected devices.

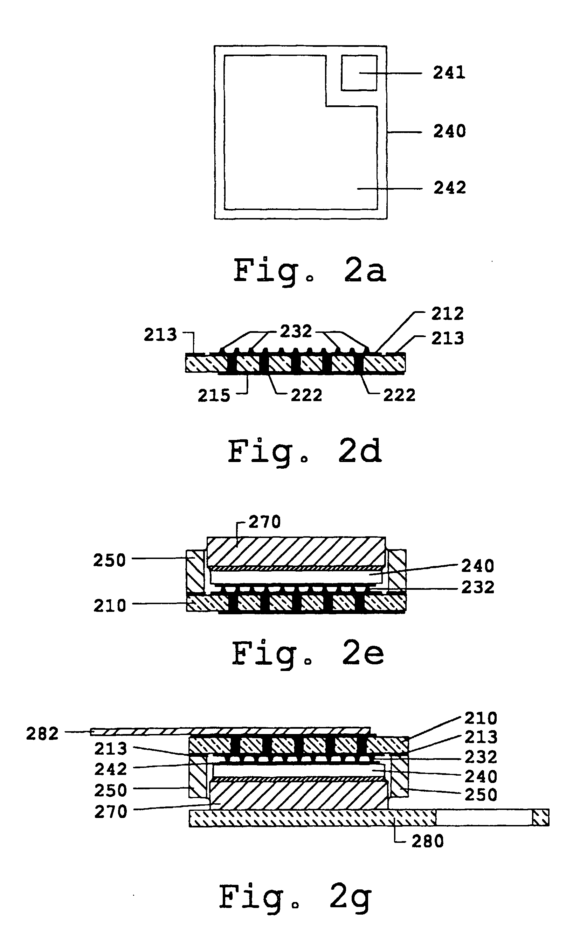

One method of preparing a package for a plurality of power semiconductors is shown in FIGs. **2a-2g**. FIG. **2a** shows a top view of an SCR die **240** which has dimensions of 6.88 mm by 6.88 mm (0.270 mils x 0.270 mils). The die has a gate contact pad **241** and an anode contact pad **242**. The cathode contact is on the reverse of the die. The cathode contact of the die is then brazed to a copper/tungsten alloy base which is 7 mm by 7 mm (0.276 mils x 0.276 mils).

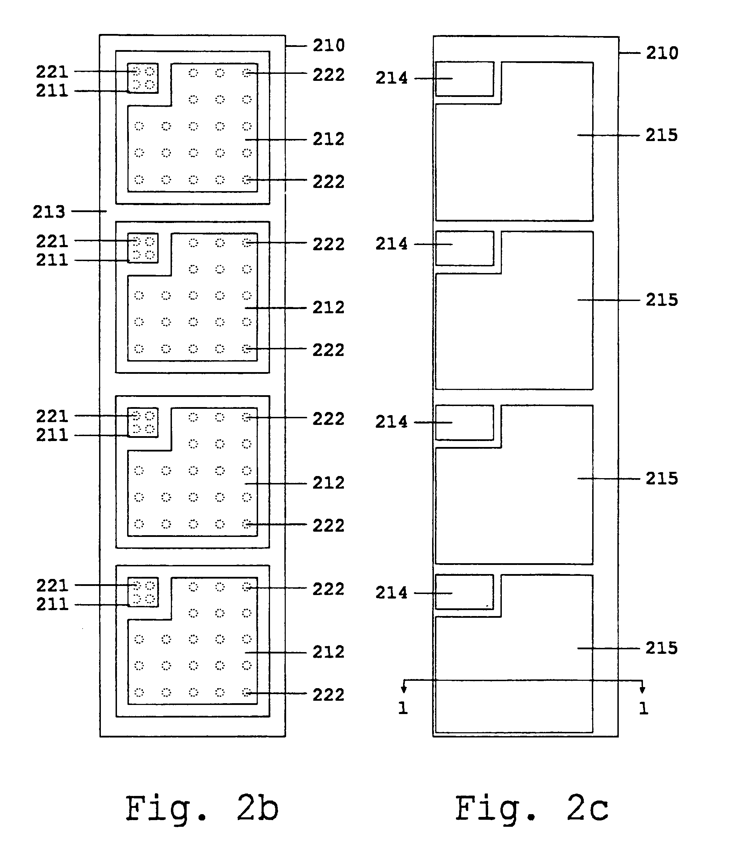

FIG. **2b** is a view of the bottom of a ceramic lid **210** which is 9.4 mm by 38 mm (0.37 inch by 1.5 inch). The bottom of the lid is provided with thick film conductors **211** and **212** which are connected to plugged vias **221** and **222**, and thick film metallization **213** surrounding the conductors **211** and **212**. The top side of the lid **210** is shown in FIG. **2c**, and has a conductive pattern layer with conductors **214** and **215** which are connected to the bottom conductive pattern layer by the plugged vias.

A plating resist is printed over the conductive pattern layers of the lid. The printed resist completely covers the top side conductors **214** and **215**, and leaves a pattern of openings over the conductors **211** and **212**. A soft, ductile gold is electroplated into the openings. FIG. **2d** shows a cross section of the lid along line 1-1 after the resist is stripped. The conductor **212** is joined to the conductor **215** by the metal filled vias **222**. The soft, ductile gold deposits form protuberances **232** above conductor **212** of the conductive pattern layer as well as the protuberances above conductor **211** which are not shown in the cross section. The number, size and distribution of the openings across the surface of the conductors is sufficient to minimize the contact resistance and maximize the power distribution in the SCR die when the lid is bonded to the die. The size of the printed openings and plated protuberances is sufficient to form reliable metallurgical bonds to the contact pads of the die, but the protuberances are not so large that the bonding pressure required for reliable metallurgical bonding by thermocompression, thermosonic or ultrasonic bonding could damage the die.

After the protuberances have been formed a Kovar frame is brazed to the conductor **213**. The inside dimensions of the frame are 0.3 mm (12 mils) larger than the copper/tungsten base. As shown in FIG. **2e**, the die **240** on the copper/tungsten base **270** is slipped inside the frame **250** and thermocompression bonded to the gold protuberances **232** on the lid **210**. Then the frame is brazed to the copper/tungsten base.

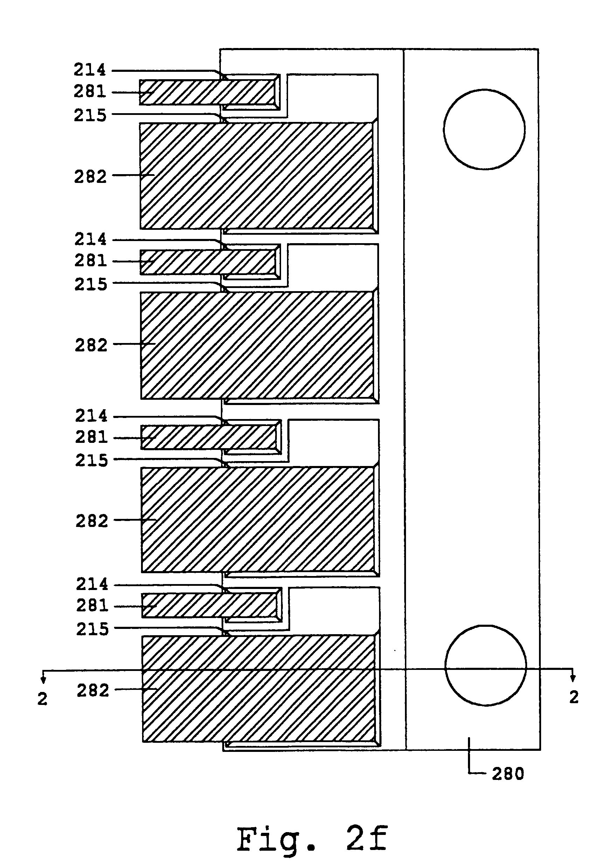

FIG. **2f** is the top view of the package containing four SCR dice on a mounted on common conductor **280**. The conductor **280** connects all the cathodes together and serves as a thermal path for connection to a heat sink. Four copper alloy leads **281**, which are soldered to the conductors **214**, serve as the gate contacts of the package, and the four copper alloy leads **282**, soldered to conductors **215**, are the anode contacts.

FIG. **2g** is a cross section view along line 2-2. The cathodes of the dice **240** are bonded to the copper/tungsten bases **270** which conduct heat and electricity to the bottom conductor **280**. The anode contacts **242** and the gate contacts (not shown) are metallurgically bonded to the protuberances **232** for anode connections and to protuberances for gate connections (not shown), and through the lid for connections to the copper tabs **282** and **281** (FIG **2f**). The frames **250** are brazed to the conductors **213** surrounding each die.

This compact unit contains four silicon controlled rectifiers (SCRs) in a package only 20 mm (0.787 inch) wide and 40 mm (1.575 inch) long.

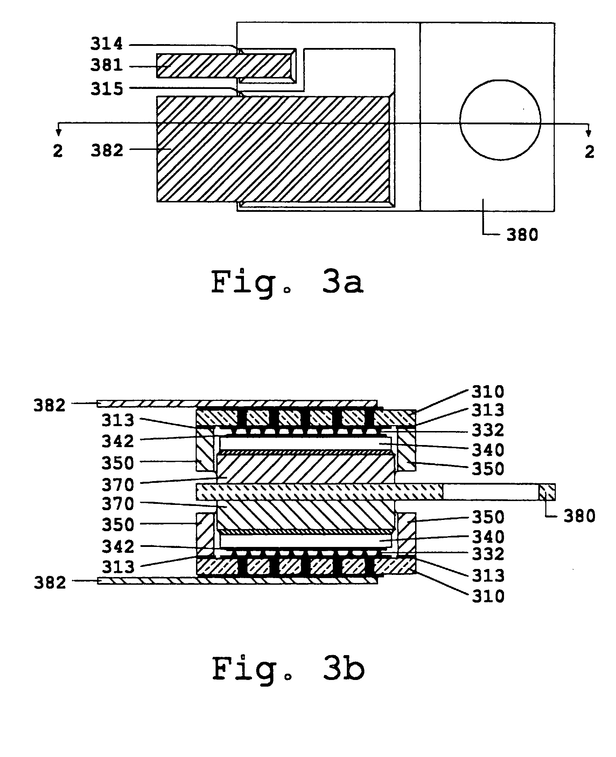

Another package for a plurality of power semiconductors is shown in FIGs. **3a** and **3b**. The package is prepared by techniques similar to those described above in reference to FIGs. **2a-2g**, and similar features have similar identifying numbers. The package has two power semiconductors mounted on the opposite sides of a metal lead. FIG. **3a** shows a top view of the package. The lid **370** has metal lead **381** bonded to the gate conductor **314**, and metal lead **382** bonded to the anode conductor **315**. The end of the cathode metal lead **380** projects from underneath the lid.

FIG. **3b** is a cross section view along line 3-3 of FIG. **3a**. The cathodes of the upper and lower chips **340** are bonded to copper/tungsten bases **370** on opposite sides of the metallic lead **380**. The anode metallization of the semiconductor **342** and the gate metallization (not shown) are metallurgically bonded to the protuberances **342** for anode connections and to protuberances for gate connections (not shown), and through the two lids **310** for connections to the metallic leads **382** and **381** (FIG. **3a**). The frames **350** are brazed to the conductors **313** surrounding each die.

This package provides a double power semiconductor package in a minimum amount of space. In this package two power semiconductors on thermally conductive bases are mounted on opposing sides of a common conductor with the two lids on the outside of the package. A similar package may be prepared with two power semiconductors being mounted on opposing sides of a common lid with the two bases on the outside of the package.

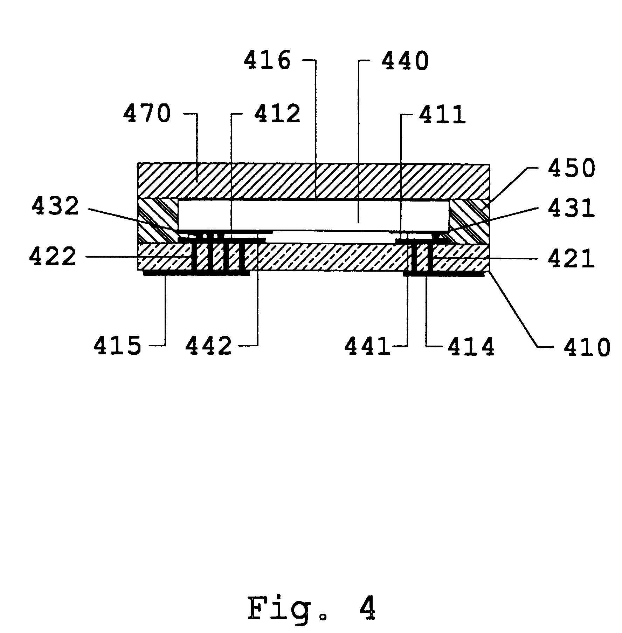

FIG. **4** shows a package utilizing a molded plastic frame. A power semiconductor **440** is bonded to a metallic base **470**. The source **442** and gate **441** metallization of the die is thermocompression bonded to the soft, ductile metal protuberances **432** and **431** on the conductors **412** and **411** of the lid **410**. The through-connections **422** and **421** in the lid connect the source and gate of the semiconductor to the source **442** and gate **441** pads of the package. To enclose and seal the package a plastic frame **450** is molded between the base and the lid.

It will be obvious to those skilled in the art that the packages and packaging techniques described herein can be applied not only to a die containing a single power semiconductor, but also to a die containing more than one power semiconductor. These packages and packaging techniques also can be applied to packages containing one or more power semiconductors and a device controlling the power devices.

## Claims

1. In a method of packaging at least one power semiconductor chip wherein a first surface of the chip is bonded to a base (170), the base being attached to a frame (150), and the frame attached to a lid (110) to enclose the chip, the chip having at least one power contact pad on its second surface, the improvement in the packaging method characterized by
providing as the lid a planar, insulating substrate having at least one conductive pattern layer on a first surface facing the chip;
forming at least one soft, ductile, metal protuberance (131, 132) on at least one first conductor of the conductive pattern layer on the first surface the lid, and
connecting the conductive pattern of the lid to the chip by metallurgically bonding the protuberances to power contact pads of the chip, the number of protuberances bonded to a power contact pad being sufficient to minimize the contact resistance and the power lost as heat (I²R) between the chip and the lid.

2. In the method of claim 1 the improvement characterized by
the conductive pattem layer on the first surface of the lid being at least partially covered by a permanent insulating layer;
openings being formed in the insulating layer, and
the protuberances on the conductive pattern layer being formed in the openings and protruding above the insulating layer.

3. In the method of claim 1 characterized in that
the conductive pattern layer on the first surface of the lid is at least partially covered by a temporary insulating layer;
openings are formed in the insulating layer;
the protuberances on the conductive pattern layer are formed in the openings; and
the temporary insulating layer is removed, the protuberances remaining on the conductive pattern layer.

4. The method of claim 1 characterized in that the protuberances are metallurgically bonded to the chip by thermocompression, thermosonic or ultrasonic bonding, and the protuberances are sufficiently large to form reliable metallurgical bonds to the power contact pad, and not so large that the bonding pressure required for reliable metallurgical bonds could damage the chip.

5. The method of claim 1 characterized in that the protuberances comprise a soft, ductile metal selected from the group consisting of aluminum, copper, gold, indium, lead, silver, and alloys and combinations of these metals.

6. In the method of claim 1 wherein the first surface of the chip is a power contact which is bonded to an electrically conductive base; the frame is a conductive metal metallurgically bonded to the base; the improvement comprising:
forming a conductive pattern on the first surface of the lid having a metallic conductor surrounding and insulated from first surface of the chip, and
forming a conductive bond between the frame and the said conductor which electrically connects the power contact on the first surface of the chip to the conductive pattern of the lid.

7. The method of claim 6 wherein the conductive pattern of the lid includes conductive vias from the conductive pattern on the first surface of the lid through the lid providing electrical contacts from the first surface of the lid to a conductive pattern layer on the second surface of the lid.

8. In the method of claim 1, the improvement for ease of assembly being characterized in that at least one side of the package, the lid with the metal protuberances or the base with the chip attached, is at least 2 mm smaller than the inside of the frame, and metallurgically bonding the chip to the protuberances of the lid, by freely sliding at least one side of the package down inside the frame to compensate for the height changes during the bonding process and for variations due to the height of the protuberances and thickness tolerances of the lid, chip and base.

9. The method of claim 8, further comprising compressing the base and chip against the lid while sealing the base and lid to the frame.

10. The method according to claim 1 characterized in that the package comprises a plurality of power semiconductor chips, each chip having at least one power semiconductor;
a first surface of each chip being bonded to a base, and each chip having at least one power contact pad on a second surface;
each chip being surrounded by a frame, the frame around each chip being bonded to the base supporting the chip;
the frames being bonded to a common lid;
the common lid being a rigid, planar, insulating substrate, the area of the substrate being large enough to accommodate the plurality of chips;
a conductive pattern on the insulating substrate, a conductive pattern layer on a first surface of the substrate comprising a plurality of soft, ductile metal protuberances, and being metallurgically bonded by the protuberances to each of the contact pads on second surfaces of the plurality of chips.

11. A package for a semiconductor chip having at least one power semiconductor, wherein a first surface of the chip is bonded to a base, the base being attached to a frame, and the frame attached to a lid to enclose the chip, the chip having at least one power contact pad on its second surface, characterized in that the lid comprises an insulating substrate having a conductive pattern at least on a first surface facing the chip, the conductive pattern of the lid being connected to the chip through of soft, ductile, metal protuberances protruding from the conductive pattern layer on the surface the lid facing the chip.
